(19) **Europäisches Patentamt / European Patent Office / Office européen des brevets**

(11) **EP 4 678 687 A1**

(12) **EUROPEAN PATENT APPLICATION**
published in accordance with Art. 153(4) EPC

(43) Date of publication:
**14.01.2026 Bulletin 2026/03**

(21) Application number: **24766941.9**

(22) Date of filing: **27.02.2024**

(51) International Patent Classification (IPC):
*C08J 5/18* (2006.01)    *B32B 7/022* (2019.01)
*B32B 25/14* (2006.01)    *B32B 27/18* (2006.01)
*B65D 65/40* (2006.01)    *B65D 85/86* (2006.01)
*C08L 25/12* (2006.01)    *C08L 55/02* (2006.01)

(52) Cooperative Patent Classification (CPC):
**B32B 7/022; B32B 25/14; B32B 27/18;**
**B65D 65/40; C08J 5/18; C08L 25/12; C08L 55/02;**
**H01L 21/00**

(86) International application number:
**PCT/JP2024/006988**

(87) International publication number:
**WO 2024/185570 (12.09.2024 Gazette 2024/37)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **06.03.2023 JP 2023033735**

(71) Applicant: **Denka Company Limited**
**Tokyo 103-8338 (JP)**

(72) Inventors:
• **YANAKA, Ryosuke**
  **Tokyo 103-8338 (JP)**
• **INODA, Ikuka**
  **Tokyo 103-8338 (JP)**
• **SODA, Katsufumi**
  **Tokyo 103-8338 (JP)**

(74) Representative: **Hoffmann Eitle**
**Patent- und Rechtsanwälte PartmbB**
**Arabellastraße 30**
**81925 München (DE)**

(54) **RESIN SHEET**

(57)    Provided is a resin sheet having excellent processability with little occurrence of burrs and fluff when punching holes, cutting, etc. Provided is a resin sheet wherein a strain value (X) calculated according to formula (1) is within a specific range.

$$\text{Formula (1): strain value (X) = fracture strain value (B) − yield strain value (A)}$$

wherein the yield strain value (A) indicates the strain value on a punching stress-punching strain curve at the moment that the punching stress is at a maximum and the fracture strain value (B) indicates the strain value on the punching stress-punching strain curve at the moment that the punching stress is zero.

**(Cont. next page)**

[FIG. 2]

Description

## TECHNICAL FIELD

The present invention relates to a resin sheet. Further, the present invention also relates to a molded article including the resin sheet.

## BACKGROUND

Resin sheets are widely used to package various intermediate or final industrial products that include electronic components. Resin sheets used for such applications can be used as molded articles that have been processed by having sprocket holes punched therein, being slit into tapes with specific widths, etc. However, burrs and fluff that arise when processing resin sheets may have adverse effects on products packaged by the resin sheets. In particular, there is the possibility that burrs or fluff will attach to an electronic component and cause a fault to occur in the electronic component in cases where the product packaged by the resin sheet is a fine electronic component. Accordingly, there is a need for resin sheets with excellent processability and the least possible occurrence of burrs or fluff.

Various attempts to improve the processability of resin sheets have been reported. For example, Patent Document 1 reports that the occurrence of burrs and fluff was reduced by using an ABS-based resin having a specific composition as a substrate layer in a surface conducting laminated sheet.

Patent Document 1: JP 2012-51249 A

## SUMMARY OF INVENTION

The present invention addresses the problem of providing a resin sheet having excellent processability with little occurrence of burrs or fluff and a molded article using the resin sheet.

The present inventors surprisingly found that the occurrence of burrs and fluff that are generated when processing a resin sheet can be effectively suppressed when the strain value of a resin sheet calculated from a punching stress-punching strain curve when a hole is punched in the resin sheet is set to a specific range, completing the present invention.

That is, the embodiments indicated below are provided according to the present invention.

[1] A resin sheet that exhibits

a strain value (X) of 5.0 to 10.0 when the resin sheet is affixed to a die having a die hole with a 2.00 mm diameter by a column-type punching pin with a diameter of 1.55 mm and a hole is punched at a punching speed of 1,000 mm/min.,

wherein the strain value (X) is calculated according to formula (1):

$$\text{strain value } (X) = \text{fracture strain value } (B) - \text{yield strain value } (A)$$

wherein the yield strain value (A) indicates the strain value on a punching stress-punching strain curve at the moment that the punching stress is at a maximum and the fracture strain value (B) indicates the strain value on the punching stress-punching strain curve at the moment that the punching stress is zero.

[2] The resin sheet described in [1], wherein the resin sheet has a substrate layer and the substrate layer includes an ABS-based resin.

[3] The resin sheet described in [1] or [2], wherein the resin sheet has a substrate layer and a surface layer laminated on at least one surface of the substrate layer, the substrate layer includes an ABS-based resin, and the surface layer includes an electrically conductive material.

[4] The resin sheet described in [2] or [3], wherein the ABS-based resin includes: a grafted rubber (I) including acrylonitrile, butadiene, and styrene; and an acrylonitrile-styrene copolymer (II), wherein the proportion of the grafted rubber (I) is 20 to 40% by mass and the proportion of the copolymer (II) is 60 to 80% by mass with respect to the total mass of the ABS-based resin,

the proportion of acrylonitrile is 5 to 15% by mass, the proportion of butadiene is 40 to 60% by mass, and the proportion of styrene is 25 to 55% by mass with respect to the total mass of the grafted rubber (I), and

the graft rate of the grafted rubber (I) is 100 to 140%.

[5] The resin sheet described in [4], wherein the copolymer (II) includes 20 to 40% by mass of acrylonitrile and 60 to 80% by mass of styrene with respect to the total mass of the copolymer (II) and has a weight-average molecular weight of 80,000 to 200,000.

[6] The resin sheet described in any of [2] to [5], wherein the substrate layer further includes an inorganic filler and the content of the inorganic filler is 30% by mass or less with respect to the total mass of the substrate layer.

[7] The resin sheet described in any of [1] to [6], wherein the resin sheet is a sheet for electronic component packaging.

[8] A molded article including the resin sheet described in any of [1] to [7].

[9] The molded article described in [8], wherein the molded article is for packaging an electronic component.

[10] The molded article described in [8] or [9], wherein the molded article is a container.

[11] The molded article described in [8] or [9], wherein the molded article is a carrier tape.

The present invention can provide resin sheet having excellent processability with little occurrence of burrs and fluff when punching holes, cutting, etc., and a molded article using the resin sheet.

## BRIEF DESCRIPTION OF DRAWINGS

Fig. 1 is a schematic (side view) of a punching apparatus used in the present invention.

Fig. 2 is an example punching stress-punching strain curve when a hole is punched in a resin sheet using a punching apparatus.

## DESCRIPTION OF EMBODIMENTS

[Explanation of terms]

In the present disclosure, numerical ranges written using the expression "to" or "-" mean that both the upper limit and the lower limit are included. For example, the description "A to B" or "A-B" using the numerical values A and B means that the value is A or greater and B or less. Further, the descriptions "A to B", "A-B", or "A or greater and B or less" independently include both "A or greater is preferable" and "B or less is preferable".
When multiple numerical ranges are described for specific parameters in the present disclosure, a suitable numerical range can be set by combining any upper limit and lower limit among the upper limits and lower limits in the numerical ranges. Further, the lower limits or upper limits of numerical ranges described in the present disclosure may be substituted with values within these numerical ranges that are indicated in examples.
In the present disclosure, "and/or" includes both the relationship represented by "and" and the relationship represented by "or". "And" is also represented by "and" or "and". "Or" is also expressed as "or".
"Include" in the present disclosure includes "is formed mainly from", "is essentially formed from", and "comprises". "Is essentially formed from" and "comprises" are included in "is formed mainly from" and "comprises" is included in "is essentially formed from".
In the present disclosure, subjects expressed in the singular with "a", "an", "the", etc. encompass singular and plural subjects unless specially and clearly indicated.
Embodiments of the present invention shall be explained in detail below, but the present invention is not limited to these embodiments and can be implemented by adding appropriate modifications as long as the effects of the present invention are not impaired. These embodiments may be used alone or multiple embodiments may be combined. When a specific explanation written for a given embodiment also applies to another embodiment, there are cases in which that explanation is omitted for the other embodiment. The publicly known features and procedures described in the present description are sufficiently understood by those skilled in the art and can be performed in accordance with the usual methods.

[Resin sheet]

The resin sheet according to the present embodiment is characterized by exhibiting a strain value (X) of 5 to 10 when a hole is punched at a punching speed of 1,000 mm/min in the resin sheet, which is affixed to a die having a die hole with a 2.00 mm diameter by a column-type punching pin with a diameter of 1.55 mm. Here, the strain value (X) is calculated according to formula (1):

$$\text{strain value (X)} = \text{fracture strain value (B)} - \text{yield strain value (A)}$$

wherein the yield strain value (A) indicates the strain value on a punching stress-punching strain curve at the moment that the punching stress is at a maximum and the fracture strain value (B) indicates the strain value on the punching stress-punching strain curve at the moment that the punching stress is zero.

The amount of burrs or fluff that occur when a hole is punched is effectively suppressed in the resin sheet according to the present embodiment. Further, a hole of a desired size can be appropriately punched in this resin sheet and cracks do not readily occur in the periphery of the hole. Therefore, the resin sheet according to the present embodiment can be suitably used for the application of packaging, for example, an electronic component, and the possibility of a fault occurring in the packaged electronic component due to burrs or fluff can be reduced.

<Measurement of punching stress (MPa) and punching strain>

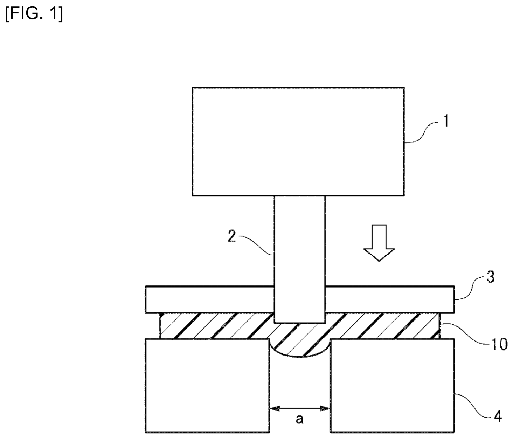

In the present embodiment, the punching stress (MPa) and punching strain are measured by a punching apparatus provided with a punching pin, a die having a die hole, a jig, and a load cell (for example, product name "Strograph VE1D" manufactured by Toyo Seiki Seisaku-sho, Ltd.). Fig. 1 shows a schematic of the punching apparatus.

The resin sheet is cut into a test piece with a height of 40 mm and a width of 40 mm, placed on the die so as to cover the die hole, and affixed by the jig. The affixed test piece is punched by one end of the punching pin. Accordingly, the diameter of the punching pin is small as compared with the diameter of the die hole. Note that the difference between the diameter of the punching pin and the diameter of the die hole is called "pin-die clearance" or "clearance". The punching speed is adjusted to a predetermined punching speed by the punching apparatus. When the resin sheet is punched, the punching stress and punching strain values are calculated and output by the punching apparatus, which is provided with a load cell that is connected to the other end of the punching pin.

In the present embodiment, the punching pin is a column-type punching pin made of gauge steel with a diameter of 1.55 mm (for example, model number PING-G2-1.55 manufactured by MISUMI Group Inc.). The diameter of the die hole is 2.0 mm (clearance: 0.45 mm). The punching speed is 1,000 mm/min. Further, the hole punching is performed in an atmosphere with a temperature of 23° C and a relative humidity of 50%.

<Strain value>

The strain value (X) is calculated according to formula (1):

$$\text{strain value (X)} = \text{fracture strain value (B)} - \text{yield strain value (A)}$$

wherein the yield strain value (A) indicates the strain value at the moment that the punching stress is at a maximum and the fracture strain value (B) indicates the strain value on the punching stress-punching strain curve at the moment that the punching stress is zero.

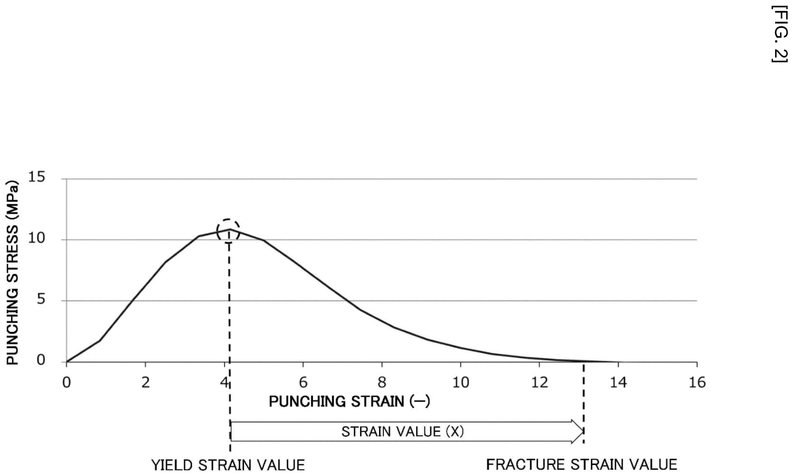

The punching stress-punching strain curve is plotted from the punching strain and punching stress values discussed above, typically using the aforementioned data analysis software. The strain value on the punching stress-punching strain curve at the moment that the punching stress is at a maximum is yield strain value (A) and the strain value on the punching stress-punching strain curve at the moment that the punching stress is zero is the fracture strain value (B). An exemplary punching stress-punching strain curve is shown in Fig. 2.

In the present embodiment, the strain value (X) of the resin sheet is 5.0 to 10.0 as discussed above, is preferably 5.0 to 9.0, and is more preferably 5.0 to 8.5. The amount of burrs that occur when processing is low in resin sheets having a strain value (X) in such a range. Further, from the perspective of more effectively suppressing both burr occurrence and hole punchability, which will be discussed below, the strain value (X) may be 5.0 to 8.0 or may be 5.0 to 7.6.

In one embodiment, the fracture strain value (B) is preferably 8.0 to 11.0 and more preferably 9.0 to 10.0. Further, the yield strain value (A) is preferably 3.0 to 6.0 and more preferably 4.0 to 5.0. The occurrence of burrs when processing is more readily suppressed in a resin sheet in which the fracture strain value (B) and the yield strain value (A) are in the abovementioned ranges and the strain value (X) calculated from formula (1) is in the range 5.0 to 10.0.

A resin sheet having a strain value (X) in the abovementioned range is more readily achieved when, for example, the resin sheet has a substrate layer that includes an ABS-based resin discussed below.

<Substrate layer>

In one embodiment, the resin sheet discussed above may have a substrate layer. The substrate layer may include an ABS-based resin.

(ABS-based resin)

The "ABS-based resin" according to the present embodiment is a resin or resin composition including a grafted rubber (I) and is preferably a resin or resin composition including a grafted rubber and a copolymer (II) of acrylonitrile and a styrene-based monomer (AS copolymer (II)). The ABS-based resin may be used alone or two or more may be used in combination.

When the resin sheet according to the present embodiment is provided with a substrate layer, the substrate layer preferably includes an ABS-based resin as a main component. Here, "includes as a main component" indicates that greater than 50% by mass, preferably 60% by mass or greater, and more preferably 70% by mass or greater of the ABS-based resin is included with respect to the total mass of the resin composition constituting the substrate layer.

In one embodiment, the content rates of the grafted rubber (I) and the AS copolymer (II) in the substrate layer are preferably 20 to 40% by mass of the grafted rubber (I) and 60 to 80% by mass of the AS copolymer (II). In a more preferred embodiment, the content rates may be in the ranges 20 to 30% by mass of the grafted rubber (I) and 70 to 80% by mass of the AS copolymer (II).

(Grafted rubber (I))

The "grafted rubber (I)" according to the present embodiment is a rubber component obtained by graft copolymerizing a vinyl cyanide monomer, a diene-based monomer, and an aromatic vinyl monomer.

The vinyl cyanide monomer is preferably acrylonitrile, methacrylonitrile, or ethacrylonitrile and especially preferably acrylonitrile. The vinyl cyanide monomer may be used alone or two or more may be used in combination. Further, the diene-based monomer is preferably 1,3-butadiene (hereafter simply described as "butadiene"), 1,3-pentadiene, or 2-methyl-1,3-butadiene (isoprene) and is especially preferably butadiene. The diene-based monomer may be used alone or two or more may be used in combination. Further, the aromatic vinyl monomer is preferably styrene, $\alpha$-methylstyrene, p-methylstyrene, or o-methylstyrene and is especially preferably styrene. The aromatic vinyl monomer may be used alone or two or more may be used in combination. The grafted rubber (I) is especially preferably a rubber component obtained by graft copolymerizing acrylonitrile, butadiene, and styrene.

The weight-average molecular weight (Mw) of the graft chains in the grafted rubber (I) is not particularly limited so long as the effects of the present invention are not impaired, but is typically 18,000 to 56,000. The weight-average molecular weight (Mw) of the graft chains in the grafted rubber (I) can be evaluated with a publicly known method as described in, for example, JP 2012-51249 A.

The volume particle diameter distribution width ((D90-D10)/D50)) of the grafted rubber (I) is not particularly limited so long as the effects of the invention are not impaired, but from the perspective of punch burr properties, is preferably 2.0 or less, more preferably 1.5 or less, and still more preferably 1.0 or less. By including a grafted rubber (I) having such a volume particle diameter distribution width, a resin sheet in which the strain value (X) is 5.0 to 10.0 is more readily obtained.

D90 of the grafted rubber (I) is preferably 2.0 to 8.0 $\mu$m and is more preferably 4.0 to 6.0 $\mu$m. Further, D50 of the grafted rubber is preferably 0.9 to 3.8 $\mu$m and more preferably 1.5 to 3.0 $\mu$m. D10 of the grafted rubber is preferably 0.3 to 2.8 $\mu$m and more preferably 1.0 to 2.0 $\mu$m. With a grafted rubber having such a D90, D50, and D10, the volume particle diameter distribution width discussed previously readily becomes 2.0 or less. Note that D90, D50, and D10 of the grafted rubber (I) are in the relationship D90 > D50 > D10 in light of the measurement principles. Here, D90 is the volume particle diameter ($\mu$m) that 90% of the particles of the grafted rubber (I) are smaller than, D50 is the volume particle diameter ($\mu$m) that 50% of the particles of the grafted rubber (I) are smaller than and the remaining 50% are greater than or equal to, and D10 is the volume particle diameter ($\mu$m) that 10% of the particles of the grafted rubber (I) are smaller than.

The D90, D50, and D10 of the grafted rubber (I) can be determined with publicly known methods. Typically, the D90, D50, and D10 are measured using a commercially available laser diffraction/scattering-type particle distribution measuring instrument (for example, laser micron sizer LMS-2000e manufactured by SEISHIN ENTERPRISE Co., Ltd.) on an ABS-based resin sample in accordance with the instruction manual for the measuring instrument, using dimethylformamide as a dispersion medium.

In one embodiment, the grafted rubber (I) preferably includes 5 to 15% by mass of acrylonitrile (An), 40 to 60% by mass of butadiene (Bd), and 25 to 55% by mass of styrene (St) with respect to the total mass of the grafted rubber (I) (provided that the total amount of An, Bd, and St does not exceed 100% by mass). In a preferred embodiment, the grafted rubber (I) may include 5 to 15% by mass of An, 40 to 55% by mass of Bd, and 40 to 55% by mass of St with respect to the total mass of the grafted rubber.

If the compositions of An, Bd, and St in the grafted rubber are within the abovementioned ranges, an ABS-based resin with a good balance of various mechanical properties is readily obtained.

Note that if the content rate of Bd is the lower limit discussed above or greater, mechanical properties of the ABS-based resin in terms of impact strength, anti-folding strength, breaking elongation, etc. tend to readily improve. Further, if the content rate of Bd is the upper limit discussed above or less, strength properties of the ABS-based resin such as yield strength tend to readily improve. In either of these cases, the occurrence of burrs or fluff when processing tends to readily decrease in a resin sheet comprising the ABS-based resin.

(Graft rate)

The graft rate of the grafted rubber (I) is preferably 100 to 140%. In one embodiment, the graft rate may be 100 to 120% or may be 120 to 140%.

Typically, the graft rate can be measured with the following method.

About 20 g of the ABS-based resin is dispersed in 100 ml of methanol and the solid components are filtered by suction filtration using a filter paper. The filtered solid components are dried for 24 hours at room temperature and then for about 4 hours with a vacuum drier. About 1.2 g of the dried solid components are placed in a 100 ml triangular flask and 30 g of methyl ethyl ketone (MEK) is added thereto. This is separated into a supernatant liquid and a sediment by stirring for 24 hours at 23° C, subjecting the solution to a centrifuge (for example, CR26H manufactured by Hitachi, Ltd., set to temperature: -9° C, rotation speed: 23,000 rpm, and time: 50 minutes) and letting the solution stand for a further 30 minutes. The supernatant liquid is poured into a 300 ml beaker containing 150 ml of methanol and the precipitate is filtered by suction filtration using a filter paper. The filtered precipitate is dried for 24 hours at room temperature and then for about 4 hours with a vacuum drier. The grafted rubber (I) is isolated from the ABS-based resin by performing the abovementioned steps of adding MEK, stirring, centrifugal separation, letting stand, precipitation, suction filtration, and drying once more on the obtained dry matter. The mass of the An monomer (y) included in the isolated grafted rubber (I) is quantified with the Kjeldahl nitrogen method and the mass (z) of the St monomer is quantified by pyrolysis gas chromatography. The graft rate is calculated from the quantity values according to the formula: graft rate $(\%) = 100 \times (y+z)/\{x-(y+z)\}$. Here, (x) is the mass of the grafted rubber (I) used in the quantification.

The strain value (X) readily enters the range previously discussed and the occurrence of burrs and fluff when processed tends to readily decrease in a resin sheet having a substrate layer including an ABS-based resin in which the graft rate is the abovementioned lower limit or greater. Further, synthesis tends to be easy with an ABS-based resin in which the graft rate is the abovementioned upper limit or less, and sufficient strength tends to readily be obtained using a resin sheet having a substrate layer including such an ABS-based resin as, for example, a sheet for electronic component packaging.

The graft rate of the grafted rubber (I) varies strictly according to the manufacturing methods of the ABS-based resins, but can be set by adjusting general polymerization conditions such as the amount of polymerization initiator to be added, the amount of chain transfer agent to be added and the time at which it is added, and the temperature control during polymerization. Further, an ABS-based resin containing a grafted rubber (I) having a graft rate in this range can be obtained commercially.

(AS copolymer (II))

The AS copolymer (II) in the present embodiment is a copolymer obtained by copolymerizing acrylonitrile and a styrene-based monomer. The same styrene-based monomers used to obtain the grafted rubber (I) discussed above can be used as the styrene-based monomer and the preferred examples are also the same. The AS copolymer (II) is especially preferably a copolymer of acrylonitrile and styrene.

In one embodiment, the AS copolymer (II) preferably includes 20 to 40% by mass of acrylonitrile (An) and 60 to 80% by mass of styrene (St) with respect to the total mass of the AS copolymer (II). In a more preferred embodiment, the AS copolymer (II) may include 20 to 30% by mass of An and 70 to 80% by mass of St.

If the compositions of An and St in the AS copolymer (II) are within these ranges, extrusion moldability of the sheet readily becomes favorable.

In one embodiment, the weight-average molecular weight of the AS copolymer (II) is preferably 80,000 to 200,000 and more preferably 100,000 to 150,000. If the weight-average molecular weight of the AS copolymer (II) is 80,000 or greater, the DuPont impact strength and anti-folding strength do not readily decrease, and if the weight-average molecular weight is 200,000 or less, the occurrence of burrs is more readily suppressed. The weight-average molecular weight of the AS copolymer (II) can be determined according to, for example, a molecular weight distribution curve using GPC (gel permeation chromatography).

(Inorganic filler)

In one embodiment, the substrate layer including the ABS-based resin discussed previously may further include an inorganic filler.

The inorganic filler is not particularly limited so long as the effects of the present invention are not impaired, but carbon black such as acetylene black, furnace black, or channel black or a silicon-containing compound such as silica is suitably used. These inorganic fillers may be used alone or two or more may be used in combination. Further, the inorganic filler typically has a particle shape in which the average primary particle diameter is 5.0 $\mu$m or less.

When the substrate layer includes an inorganic filler, the content of the inorganic filler is preferably 30% by mass or less and more preferably 28% by mass or less with respect to the total mass of the substrate layer. In a more preferred embodiment, the content of the inorganic filler may be 1 to 30% by mass, may be 1 to 28% by mass, or may be 1 to 25% by mass with respect to the total mass of the substrate layer.

When the substrate layer includes the inorganic filler in the abovementioned range, the amount of burrs that occur when processing the resin sheet tends to be suppressed and cracks do not readily occur in the periphery of the hole when a hole is punched in the resin sheet under the conditions discussed previously.

(Other components)

In one embodiment, the substrate layer may include resin components other than the ABS-based resin (other resins) or various additives in a range not exceeding 50% by mass. Examples of other resins include polycarbonate (PC)-based resins, polybutylene terephthalate (PBT)-based resins, etc., but the other resins are not limited thereto. Examples of additives include modifiers, lubricants, plasticizers, and processing aids, but the additives are not limited thereto. Note that from the perspective of readily controlling the strain value (X) of the resin sheet to be in the range of 5.0 to 10.0, the substrate layer preferably includes only an ABS-based resin as a resin component.

Further, the substrate layer may include recycled materials so long as the effects of the present invention are not impaired. Recycled materials are generally materials where portions at both ends (generally called "edges") of sheets generated when extruding a resin sheet in manufacturing processes for resin sheets or trimmed portions that cannot be made into products such as the initial end portion when winding a sheet are crushed, re-pelletized, and reused. When the substrate layer includes a recycled material, the content of components that the substrate layer includes can also be adjusted according to the content of the components that the recycled material includes. In one embodiment, the substrate layer includes 2 to 30% by mass, preferably 2 to 25% by mass, and more preferably 2 to 20% by mass of recycled material with respect to the total mass of the substrate layer.

Further, the substrate layer may include trace components derived from raw materials or other trace components so long as the effects of the present invention are not impaired. Examples of such trace components include $\alpha$-methylstyrene, vinyltoluene, dimethylstyrene, chlorostyrene, vinylnaphthalene, methacrylonitrile, ethacrylonitrile, fumaronitrile, etc., but the trace components are not limited thereto. Although descriptions of trace components are omitted below, the surface layer, resin, polymer, composition, resin composition, etc. in the present embodiment all include those which contain such trace components in a range that does not impair the effects of the invention of the present application.

<Surface layer>

In one embodiment, the resin sheet may have a substrate layer and a surface layer laminated on at least one surface of the substrate layer. The substrate layer may be a substrate layer including the ABS-based resin discussed previously and the surface layer may include an electrically conductive material. Due to the resin sheet having a substrate layer and a surface layer, the strain value (X) is more readily controlled to be within the range of 5.0 to 10.0.

The surface layer may be laminated on one surface of the substrate layer or may be laminated on both surfaces of the substrate layer. When the configuration is that where the surface layer has been laminated on both surfaces of the substrate layer, the proportions of the electrically conductive material included in the one surface layer and in the other surface layer may be the same or may differ. Further, the thicknesses of the one surface layer and the other surface layer may be the same or may differ.

In one embodiment, the surface layer is preferably the outermost layer of the resin sheet. Further, in one embodiment, the surface layer may be laminated on only one surface of the substrate layer and may constitute the outermost layer of the resin sheet. When the resin sheet has a surface layer and especially when the surface layer is the outermost layer of the resin sheet, the amount of burrs that occur when processing the resin sheet tends to be suppressed.

The surface layer is not particularly limited so long as it is a layer including an electrically conductive material. For example, electrically conductive microparticles wherein electrical conductivity has been imparted to a sulfide such as zinc sulfide, copper sulfide, cadmium sulfide, nickel sulfide, or palladium sulfide; barium sulfate or a metal oxide such as tin oxide, zinc oxde, indium oxide, or titanium oxide; electrically conductive carbon microparticles (carbon black); a silicon-containing organic compound, a surface metal-plated microparticle, etc. can be used as the electrically conductive material. These may be used alone or two or more may be used in combination. Among these electrically conductive materials, carbon black, with which high electrical conductivity is readily obtained with a small amount added, is suitably used. Examples of carbon black include acetylene black, furnace black, channel black, etc., but the carbon black is not limited thereto. Carbon black having a volume particle diameter with a large specific surface area such that a high electrical conductivity is obtained with a small amount added is preferred. Specifically, the average primary volume particle diameter of the carbon black is preferably 10 to 100 nm and more preferably 20 to 60 nm. The average primary volume particle diameter can be measured using, for example, a transmission electron microscope. The electrically conductive material may be the same as the inorganic filler discussed previously which the substrate layer includes.

The surface layer preferably includes 5 to 40% by mass and more preferably 10 to 30% by mass of the electrically conductive material with respect to the total mass of the surface layer. Further, the surface layer may include one or more resins among polystyrene-based resins, ABS-based resins, polyvinyl chloride-based resins, polypropylene-based resins, polyester-based resins, polyphenylene ether-based resins, polybutylene terephthalate-based resins, and polycarbonate-based resins. In this case, the surface layer preferably includes 60 to 95% by mass and more preferably 70 to 90% by mass of these resins with respect to the total mass of the surface layer.

The surface layer may include various additives. Examples of additives include modifiers, lubricants, plasticizers, and processing aids, but the additives are not limited thereto.

Further, the surface layer may include the recycled material discussed previously so long as the effects of the present invention are not impaired. In this case, the content of components that the surface layer includes can also be adjusted according to the content of the components that the recycled material includes. In one embodiment, the surface layer includes 2 to 30% by mass, preferably 2 to 25% by mass, and more preferably 2 to 20% by mass of recycled material with respect to the total mass of the surface layer.

<Total thickness of the resin sheet and thicknesses of the substrate layer and surface layer>

The total thickness of the resin sheet and the thicknesses of the substrate layer and surface layer can be set to any thickness as long as the effects of the present invention are not impaired. For example, the total thickness of the resin sheet may be 50 to 700 $\mu$m, preferably 75 to 500 $\mu$m, and more preferably 100 to 300 $\mu$m. The thickness of the substrate layer may be 50 to 700 $\mu$m, preferably 75 to 500 $\mu$m, and more preferably 100 to 300 $\mu$m. The thickness of the surface layer may be 1 to 100 $\mu$m, preferably 5 to 75 $\mu$m, and more preferably 10 to 50 $\mu$m.

In one embodiment, the ratio of the thickness of the substrate layer and the thickness of the surface layer (substrate layer thickness/surface layer thickness) may be in the range of 90/10 to 60/40.

These thicknesses can be evaluated with publicly known methods. Publicly known methods include, for example, analysis using a microscope, etc. Typically, these thicknesses are evaluated by using a shape-analyzing laser microscope (for example, shape measurement laser microscope VK-X100 manufactured by Keyence Corporation) to measure the thicknesses of the resin sheet and the layers in a cross section of a sample that was cut out with a single-edged knife. Further, when the resin sheet was extruded by an extruder, these thicknesses are typically evaluated from average values of the measurements at the center and at both ends of the cross section in a direction perpendicular to the direction of flow of the resin sheet.

The resin sheet according to the present embodiment may also have arbitrary layers beyond the substrate layer and the surface layer. Further, the substrate layer and the surface layer each may be a single-layer structure or may be a multilayer structure.

[Use]

The resin sheet according to the present embodiment is typically a resin sheet that can be used as a material of a molded body for packaging an intermediate or final industrial product. The industrial product is typically an electronic component or a product that includes electronic components. That is, in the present embodiment, the resin sheet may be used as a sheet for electronic component packaging.

Examples of electronic components or products including electronic components include semiconductors, integrated circuits (ICs), light-emitting diodes (LEDs), diodes, resistors, capacitors, transistors, piezoelectric element registers, filters, crystal oscillators, crystal resonators, connectors, switches, volumes, relays, inductors, and combinations thereof, but the electronic components or products including the same are not limited thereto.

There are also use of the abovementioned sheet as a sheet for electronic component packaging and methods of use thereof as other embodiments of the abovementioned resin sheet.

The resin sheet according to the present embodiment has good processability. For example, the amount of burrs and fluff that occur when the resin sheet is cut, a hole is opened in the resin sheet, etc. is effectively suppressed in the resin sheet according to the present embodiment. Therefore, the possibility of a fault occurring in an electronic component due to burrs or fluff is reduced when, for example, the electronic component is packaged by a molded article that includes the resin sheet according to the present embodiment.

[Method of manufacturing the sheet] In these embodiments the method of manufacturing the resin sheet is not particularly limited and the sheet can be manufactured with general methods. For example, when the resin sheet is a multilayer structure, the resin sheet can be suitably manufactured by respectively providing the raw materials constituting each layer to separate extruders and extrusion-molding using a multilayer T-die having a multi-manifold or using a T-die extrusion-molding method using a feed block.

[Molded article and manufacturing method therefor]

In these embodiments, the molded article can be obtained by processing a resin sheet according to these embodiments. Processing the sheet can be carried out with publicly known methods including vacuum molding, pressure molding, and press molding. Further, processing the sheet may include a step of cutting the sheet into a desired shape or a step of punching sprocket holes into the sheet.

The molded article according to the present embodiment is typically a molded article for packaging an electronic component. In one embodiment, the molded article may be a container and in particular may be a container having a storage part for storing an electronic component. Further, in one embodiment, the molded article may be a carrier tape and in particular may be a carrier tape on which an embossing process has been performed.

**EXAMPLES**

The present invention will be explained in detail by indicating examples below, but the present invention is not limited by the descriptions below.

[Fabrication of the resin sheet]

(Examples 1 to 8 and Comparative Examples 1 to 9)

In Examples 1 to 8 and Comparative Examples 1 to 5, ABS-based resins (ABS 1 to ABS 5) prepared with publicly known polymerization methods and publicly known mixing methods are used as the substrate layer. Examples of publicly known polymerization methods include emulsion polymerization, bulk polymerization, and solution polymerization, and examples of publicly known mixing methods include homogeneous mixing with a high-speed mixer.

Table 1 shows the compositions of grafted rubbers (I) 1 to 5 respectively included in ABS 1 to ABS 5 and the D90, D50, and D10, volume particle diameter distribution width, and graft values thereof. Note that the D90, D50, and D10 were measured using laser micron sizer LMS-2000e (manufactured by SEISHIN ENTERPRISE Co., Ltd.) in accordance with the instruction manual for the measuring instrument, using dimethylformamide as a dispersion medium. Table 2 shows the compositions of the AS copolymers (II) included in ABS 1 to ABS 5. Table 3 shows the types of grafted rubbers (I) included in ABS 1 to ABS 5 and the grafted rubber (I) and AS copolymer (II) content. Table 4 shows the compositions of the resin sheets of the examples and comparative examples. Note that the numerical values for An, Bd, and St in Table 1 show the % by mass with respect to the total mass of the grafted rubber (1). The numerical values for An and St in Table 2 show the % by mass with respect to the total mass of the AS copolymer (II). The numerical values for the grafted rubber (I) and the copolymer (II) in Table 3 show the % by mass with respect to the total mass of the ABS-based resins. The numerical values for the compositions (PC, PBT, and acetylene black) of the surface layers in Table 4 show the % by mass with respect to the total mass of the surface layer and the numerical values for the compositions of the substrate layers (ABS 1 to ABS 5, PBT, AS, GPPS, LLDPE, LDPE, acetylene black, and silica) show the % by mass with respect to the total mass of the substrate layer.

EP 4 678 687 A1

Table 1

| | | An | Bd | St | D90 (μm) | D50 (μm) | D10 (μm) | VOLUME PARTICLE DIAMETER DISTRIBUTION WIDTH (μm) | GRAFT RATE (%) |
|---|---|---|---|---|---|---|---|---|---|
| GRAFTED RUBBER (I) | 1 | 10 | 45 | 45 | 3.0 | 2.3 | 1.8 | 0.5 | 120 |
| | 2 | 6 | 53 | 41 | | | | | |
| | 3 | 4 | 35 | 61 | | | | | |
| | 4 | 20 | 70 | 10 | | | | | |
| | 5 | 10 | 45 | 45 | 3.0 | 2.8 | 2.6 | 0.1 | 120 |

Table 2

| | An | St | Mw (×10,000) |
|---|---|---|---|
| AS COPOLYMER (II) | 25 | 75 | 13.5 |

Table 3

| | | ABS 1 | ABS 2 | ABS 3 | ABS 4 | ABS 5 |
|---|---|---|---|---|---|---|
| GRAFTED RUBBER (I) | 1 | 25 | | | | |
| | 2 | | 25 | | | |
| | 3 | | | 25 | | |
| | 4 | | | | 25 | |
| | 5 | | | | | 25 |
| AS COPOLYMER (II) | | 75 | 75 | 75 | 75 | 75 |

Table 4

| SUR-FACE LAYER / SUBSTRATE LAYER | Item | EXAMPLE 1 | EXAMPLE 2 | EXAMPLE 3 | EXAMPLE 4 | EXAMPLE 5 | EXAMPLE 6 | EXAMPLE 7 | EXAMPLE 8 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 | COMPARATIVE EXAMPLE 7 | COMPARATIVE EXAMPLE 8 | COMPARATIVE EXAMPLE 9 |
|---|---|---|---|---|---|---|---|---|---|---|---|---|---|---|---|---|---|---|
| SURFACE LAYER | COMPOSITION — PC | 65 | 65 | | 65 | 65 | | | | 65 | 65 | | | 65 | | | | |
| | COMPOSITION — PBT | 20 | 20 | | 20 | 20 | | | | 20 | 20 | | | 20 | | | | |
| | COMPOSITION — ACETYLENE BLACK | 15 | 15 | | 15 | 15 | | | | 15 | 15 | | | 15 | | | | |
| | SURFACE LAYER THICKNESS (μm) | 28 | 28 | | 28 | 28 | | | | 28 | 28 | | | 28 | | | | |
| SUBSTRATE LAYER | COMPOSITION — ABS 1 | 99 | | | 85 | 75 | 85 | 75 | 85 | | | | 65 | 65 | | | | |
| | COMPOSITION — ABS 2 | | 99 | | | | | | | 99 | | | | | | | | |
| | COMPOSITION — ABS 3 | | | | | | | | | | 99 | | | | | | | |
| | COMPOSITION — ABS 4 | | | 100 | | | | | | | | | | | | | | |
| | COMPOSITION — ABS 5 | | | | | | | | | | | 100 | | | | | | |
| | COMPOSITION — PBT | | | | | | | | | | | | | | 100 | | | |
| | COMPOSITION — AS | 1 | 1 | | | | | | | 1 | 1 | | | | | | | |
| | COMPOSITION — GPPS | | | | | | | | | | | | 35 | 35 | | 100 | | |
| | COMPOSITION — LLDPE | | | | | | | | | | | | | | | | 100 | |
| | COMPOSITION — LDPE | | | | | | | | | | | | | | | | | 100 |
| | COMPOSITION — ACETYLENE BLACK | | | | 15 | 25 | 15 | 25 | | | | | | | | | | |
| | COMPOSITION — SILICA | | | | | | | | 15 | | | | | | | | | |
| | SUBSTRATE LAYER THICKNESS (μm) | 172 | 172 | 200 | 172 | 172 | 200 | 200 | 200 | 172 | 172 | 200 | 200 | 172 | 200 | 200 | 200 | 200 |
| RESIN SHEET TOTAL THICKNESS (μm) | | 200 | 200 | 200 | 200 | 200 | 200 | 200 | 200 | 200 | 200 | 200 | 200 | 200 | 200 | 200 | 200 | 200 |

(continued)

| | | | EXAMPLE 1 | EXAMPLE 2 | EXAMPLE 3 | EXAMPLE 4 | EXAMPLE 5 | EXAMPLE 6 | EXAMPLE 7 | EXAMPLE 8 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 | COMPARATIVE EXAMPLE 7 | COMPARATIVE EXAMPLE 8 | COMPARATIVE EXAMPLE 9 |
|---|---|---|---|---|---|---|---|---|---|---|---|---|---|---|---|---|---|---|---|
| | STRAIN VALUE (X) | | 7.6 | 8.1 | 6.0 | 5.8 | 5.2 | 6.0 | 5.5 | 6.0 | 3.8 | 14.0 | 12.0 | 4.0 | 4.5 | 1.7 | 3.3 | 30 < | 30 < |
| EVALUATION | HOLE PUNCHABILITY | DETERMINATION | PASS | PASS | PASS | PASS | PASS | PASS | PASS | PASS | FAIL (2) | PASS | PASS | FAIL (2) | FAIL (2) | FAIL (2) | FAIL (2) | FAIL (1) | FAIL (1) |
| | PUNCH BURR PROPERTIES | DETERMINATION | EXCELLENT | GOOD | EXCELLENT | EXCELLENT | EXCELLENT | EXCELLENT | EXCELLENT | EXCELLENT | - | FAIL | FAIL | - | - | - | - | - | - |
| | | BURRS (NUMBER) | 2 | 9 | 2 | 1 | 0 | 2 | 1 | 2 | - | 20 | 16 | - | - | - | - | - | - |

In Table 4, PBT is polybutylene terephthalate, AS is acrylonitrile styrene, GPPS is general-purpose polystyrene, LLDPE is linear low-density polyethylene, and LDPE is low-density polyethylene.

Acetylene black (manufactured by Denka Company Limited, product name: "DENKA BLACK® Granular", average primary particle diameter: 35 nm) or silica (manufactured by Admatechs, product name: "YA010C", average primary particle diameter: 10 nm) was used as the inorganic filler in Examples 1, 2, and 4 to 8 and Comparative Examples 1, 2, 4, and 5.

Further, for the surface layer, resin compositions obtained by using a φ 30 mm vented twin-screw extruder to knead 80% by mass of a polycarbonate resin (manufactured by Teijin Ltd., product name "Panlite® L-1225L") and 20% by mass of acetylene black (manufactured by Denka Company Limited, product name: "DENKA BLACK® Granular", average primary particle diameter: 35 nm) as the electrically conductive material and pelletizing with a strand cutting method were used. Regarding Examples 1 and 2, Examples 4 and 5, and Comparative Examples 1, 2, and 5, resin sheets were obtained by using the substrate layer resin compositions and surface layer resin compositions described in Tables 1 to 3 to form surface layers on both surfaces of the substrate layer with a feed block method using a φ 65 mm extruder (L/D = 28), a φ 50 mm extruder (L/D = 28), a φ 40 mm extruder (L/D = 26), and a T-die with a width of 500 mm. The resin sheets of Examples 3 and 6 to 8 and Comparative Examples 3, 4, and 6 to 9 were prepared by extruding resin compositions using a φ 65 mm extruder (L/D = 28)

Using test pieces cut out from the resin sheets with a single-edged knife, the total thickness of the obtained resin sheets and the thicknesses of the substrate layer and the surface layer were measured by a shape measurement laser microscope VK-X100 (manufactured by Keyence Corporation). The thicknesses of both ends of the cross section in a direction perpendicular to the direction of the flow of the sheet (TD direction), the center, and the cross section were measured and the average values thereof used in evaluation. The results are shown in Table 4.

[Resin sheet evaluation]

The resin sheets obtained in each of the examples were cut in the extrusion direction of the resin sheets to fabricate sheet samples which were left for 24 hours in an atmosphere with a temperature of 23° C and a relative humidity of 50%. The strain value (X) in each example was evaluated thereafter. Furthermore, the relationship between the strain value (X) and the hole punchability and punch burr properties was investigated.

(Strain value (X))

A punching stress-punching strain curve when a hole is punched using a punching apparatus under the following conditions was plotted for the resin sheet of each example.

<Conditions>

Punching pin diameter: 1.55 mm

Punching speed: 1,000 mm/min.

Die hole diameter: 2.00 mm (pin-die clearance: 0.45 mm)

Temperature: 23° C

Relative humidity: 50%

Test piece size: 40-mm height × 40-mm width

The thickness is equal to the total thickness of the resin sheet.

The strain values (X) were calculated from the obtained punching stress-punching strain curves using formula (1):

$$\text{strain value (X)} = \text{fracture strain value (B)} - \text{yield strain value (A)}$$

wherein the yield strain value (A) indicates the strain value at the moment that the punching stress is at a maximum and the fracture strain value (B) indicates the strain value on the punching stress-punching strain curve at the moment that the punching stress is zero.

Product name "Strograph VE1D" manufactured by Toyo Seiki Seisaku-sho, Ltd. provided with pin made of gauge steel (model number PING-G2-1.55 manufactured by MISUMI Group Inc) and a die was used as the punching apparatus. Fig. 1 shows a schematic of the punching apparatus.

(Hole punchability)

Punching and the shape of punched holes in sheet samples that were slitted to a width of 8 mm were evaluated using a vacuum rotary molder (product name: "CT 8/24" manufactured by Mühlbauer GmbH & Co. KG) in at atmosphere with a temperature of 23° C and a relative humidity of 50%. Note that punching was performed at a speed of 240 m/h using a punching apparatus provided with a column-type punching pin with a sprocket hole pin tip diameter of 1.5 mm and a die hole with a diameter of 1.58 mm.

The standard for determining the hole punchability is as follows.

<Determination criteria>

    Pass: The diameter of the punched hole is 1.3 to 1.7 mm.

    Fail (1): The diameter of the punched hole is less than 1.3 mm or greater than 1.7 mm.

    Fail (2): Cracks developed in the vicinity of the punched hole.

(Punch burr properties)

Punching and hole burrs and fluff in sheet samples that were slitted to a width of 8 mm were evaluated using a vacuum rotary molder (product name: "CT 8/24" manufactured by Mühlbauer GmbH & Co. KG) in at atmosphere with a temperature of 23° C and a relative humidity of 50%.

Punching was performed at a speed of 240 m/h using a punching apparatus provided with a column-type punching pin with a sprocket hole pin tip diameter of 1.5 mm and a die hole with a diameter of 1.58 mm.

The holes in the resin sheet generated by punching were captured, in an illumination environment with an incident light of 0%, transmission of 40%, and a ring of 0%, using a measuring microscope (product name "MF-A1720H (image unit 6D)" manufactured by Mitutoyo Corporation). Holes with a diameter of 1.5 mm were observed at ten locations and the number of burrs and fluffs with a length of 0.15 mm or more was counted. Further, evaluations were made in accordance with the following determination criteria, with good or higher being deemed to be a pass (occurrence of burrs and fluffs is inhibited).

The standard for determining the punch burr properties is as follows.

<Determination criteria>

    Excellent: The number of burrs or fluffs was less than six.

    Good: The number of burrs or fluffs was six or greater and less than ten.

    Fail: The number of burrs or fluffs was ten or greater.

The results of the above are shown in Table 4.

As shown in Table 4, the resin sheets of Examples 1 to 8 in which the strain value (X) is in the range of 5.0 to 10.0 demonstrated good hole punchability and good punch burr properties.

Meanwhile, there were problems in processability such as cracks developing in the vicinity of the punched hole (Fail (2)) in hole punchability testing on the resin sheets of Comparative Examples 1 and 4 to 7, in which the strain value (X) is lower than the abovementioned range. Moreover, there were 10 or greater burrs or fluffs (fail) in testing the punch burr properties of the resin sheets of Comparative Examples 2 and 3, in which the strain value (X) is higher than the abovementioned range. Furthermore, it was not possible to punch a hole of a desired size (Fail (1)) in testing the hole punchability of the resin sheet of Comparative Example 8, in which the strain value (X) is yet higher.

From the results above, it is shown that the resin sheet of the present invention has excellent processability, is useful for, for example, the application of packaging electronic components, and is capable of effectively suppressing the possibility that faults in electronic components will occur due to burrs or fluff.

Note that the disclosed details of the patents, patent applications, and publications cited in the present disclosure are invoked in their entirety by reference in the present disclosure.

## INDUSTRIAL APPLICABILITY

The resin sheet of the present application has good processability and therefore can suitably be used as a packaging sheet for industrial products (for example, electronic components including semiconductors, integrated circuits (ICs), light-emitting diodes (LEDs), diodes, resistors, capacitors, transistors, piezoelectric element registers, filters, crystal oscillators, crystal resonators, connectors, switches, volumes, relays, inductors, combinations thereof, etc.). Accordingly, the present invention has industrial applicability.

## REFERENCE SIGNS LIST

1    Load cell

2    Punching pin

3    Jig

4    Die

a    Die hole diameter

## Claims

1.  A resin sheet that exhibits

    a strain value (X) of 5.0 to 10.0 when the resin sheet is affixed to a die having a die hole with a 2.00 mm diameter by a column-type punching pin with a diameter of 1.55 mm and a hole is punched at a punching speed of 1,000 mm/min.,
    wherein the strain value (X) is calculated according to formula (1):

    $$\text{strain value (X)} = \text{fracture strain value (B)} - \text{yield strain value (A)}$$

    wherein the yield strain value (A) indicates the strain value on a punching stress-punching strain curve at the moment that the punching stress is at a maximum and the fracture strain value (B) indicates the strain value on the punching stress-punching strain curve at the moment that the punching stress is zero.

2.  The resin sheet according to claim 1, wherein the resin sheet has a substrate layer and the substrate layer comprises an ABS-based resin.

3.  The resin sheet according to claim 1, wherein the resin sheet has a substrate layer and a surface layer laminated on at least one surface of the substrate layer, the substrate layer comprises an ABS-based resin, and the surface layer comprises an electrically conductive material.

4.  The resin sheet according to claim 2 or 3, wherein the ABS-based resin comprises: a grafted rubber (I) comprising acrylonitrile, butadiene, and styrene; and an acrylonitrile-styrene copolymer (II), wherein the proportion of the grafted rubber (I) is 20 to 40% by mass and the proportion of the copolymer (II) is 60 to 80% by mass with respect to the total mass of the ABS-based resin,

the proportion of acrylonitrile is 5 to 15% by mass, the proportion of butadiene is 40 to 60% by mass, and the proportion of styrene is 25 to 55% by mass with respect to the total mass of the grafted rubber (I), and the graft rate of the grafted rubber (I) is 100 to 140%.

5. The resin sheet according to claim 4, wherein the copolymer (II) comprises 20 to 40% by mass of acrylonitrile and 60 to 80% by mass of styrene with respect to the total mass of the copolymer (II) and has a weight-average molecular weight of 80,000 to 200,000.

6. The resin sheet according to claim 4, wherein the substrate layer further comprises an inorganic filler and the content of the inorganic filler is 30% by mass or less with respect to the total mass of the substrate layer.

7. The resin sheet according to any one of claims 1 to 3, wherein the resin sheet is a sheet for electronic component packaging.

8. A molded article comprising the resin sheet according to any one of claims 1 to 3.

9. The molded article according to claim 8, wherein the molded article is for packaging an electronic component.

10. The molded article according to claim 8, wherein the molded article is a container.

11. The molded article according to claim 8, wherein the molded article is a carrier tape.

[FIG. 1]

[FIG. 2]

## INTERNATIONAL SEARCH REPORT

| International application No. |
|---|
| **PCT/JP2024/006988** |

---

**A. CLASSIFICATION OF SUBJECT MATTER**

*C08J 5/18*(2006.01)i; *B32B 7/022*(2019.01)i; *B32B 25/14*(2006.01)i; *B32B 27/18*(2006.01)i; *B65D 65/40*(2006.01)i; *B65D 85/86*(2006.01)i; *C08L 25/12*(2006.01)i; *C08L 55/02*(2006.01)i
FI: C08J5/18 CEY; B32B27/18 J; B32B25/14; B32B7/022; C08L55/02; C08L25/12; B65D65/40 D; B65D85/86 300

According to International Patent Classification (IPC) or to both national classification and IPC

**B. FIELDS SEARCHED**

Minimum documentation searched (classification system followed by classification symbols)

C08J5/18; B32B7/022; B32B25/14; B32B27/18; B65D65/40; B65D85/86; C08L25/12; C08L55/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2022/030096 A1 (DENKA CO., LTD.) 10 February 2022 (2022-02-10) claims, paragraphs [0084]-[0106], examples | 1-3, 6-11 |
| Y | | 4, 5 |
| X | WO 2021/187198 A1 (DENKA CO., LTD.) 23 September 2021 (2021-09-23) claims, paragraphs [0067]-[0077], examples | 1-3, 6-11 |
| Y | | 4, 5 |
| X | JP 2005-297504 A (DENKI KAGAKU KOGYO KABUSHIKI KAISHA) 27 October 2005 (2005-10-27) claims, paragraphs [0023]-[0041], examples 1-5, comparative example 5 | 1-3, 7-11 |
| Y | | 4, 5 |
| Y | JP 2012-051249 A (DENKI KAGAKU KOGYO KABUSHIKI KAISHA) 15 March 2012 (2012-03-15) claims, paragraph [0006] | 4, 5 |

☑ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **01 May 2024** | **21 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
|---|
| **PCT/JP2024/006988** |

**C.    DOCUMENTS CONSIDERED TO BE RELEVANT**

| Category* | Citation of document, with indication, where appropriate, of the relevant passages | Relevant to claim No. |
|---|---|---|
| Y | WO 2011/118522 A1 (DENKI KAGAKU KOGYO KABUSHIKI KAISHA) 29 September 2011 (2011-09-29)<br>claims, paragraph [0006] | 4, 5 |
| A | WO 2014/007135 A1 (SUMITOMO BAKELITE CO., LTD.) 09 January 2014 (2014-01-09)<br>claims, examples | 1-11 |
| A | WO 2012/046807 A1 (DENKI KAGAKU KOGYO KABUSHIKI KAISHA) 12 April 2012 (2012-04-12)<br>claims, examples | 1-11 |

Form PCT/ISA/210 (second sheet) (July 2022)

## INTERNATIONAL SEARCH REPORT
### Information on patent family members

International application No.

**PCT/JP2024/006988**

| Patent document cited in search report | | | Publication date (day/month/year) | Patent family member(s) | | | Publication date (day/month/year) |
|---|---|---|---|---|---|---|---|
| WO | 2022/030096 | A1 | 10 February 2022 | US claims, paragraphs [0099]-[0149], examples | 2023/0279190 | A1 | |
| | | | | CN | 115996842 | A | |
| | | | | KR | 10-2023-0047958 | A | |
| | | | | TW | 202208523 | A | |
| WO | 2021/187198 | A1 | 23 September 2021 | US claims, paragraphs [0078]-[0101], examples | 2023/0084488 | A1 | |
| | | | | EP | 4043212 | A1 | |
| | | | | CN | 114667218 | A | |
| | | | | KR | 10-2022-0153569 | A | |
| | | | | TW | 202200383 | A | |
| JP | 2005-297504 | A | 27 October 2005 | (Family: none) | | | |
| JP | 2012-051249 | A | 15 March 2012 | (Family: none) | | | |
| WO | 2011/118522 | A1 | 29 September 2011 | US claims, paragraph [0010] | 2013/0017350 | A1 | |
| | | | | CN | 102821951 | A | |
| | | | | KR | 10-2013-0000413 | A | |
| WO | 2014/007135 | A1 | 09 January 2014 | JP | 2014-0009337 | A | |
| | | | | CN | 104395397 | A | |
| | | | | KR | 10-2015-0032940 | A | |
| | | | | TW | 201420339 | A | |
| WO | 2012/046807 | A1 | 12 April 2012 | US claims, examples | 2013/0251970 | A1 | |
| | | | | EP | 2626203 | A1 | |
| | | | | CN | 103153614 | A | |

Form PCT/ISA/210 (patent family annex) (July 2022)

**EP 4 678 687 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012051249 A